Europäisches Patentamt

European Patent Office

Office européen des brevets

(19)

(11) Veröffentlichungsnummer: **0 331 614**
**A1**

(12) **EUROPÄISCHE PATENTANMELDUNG**

(21) Anmeldenummer: 89730036.4

(22) Anmeldetag: 20.02.89

(51) Int. Cl.⁴: **G 01 R 1/073**
G 01 R 31/28, H 01 R 31/06

(30) Priorität: 29.02.88 DE 3806793

(43) Veröffentlichungstag der Anmeldung:
06.09.89 Patentblatt 89/36

(84) Benannte Vertragsstaaten:
AT BE CH DE FR GB IT LI NL SE

(71) Anmelder: **Siemens Aktiengesellschaft**
**Wittelsbacherplatz 2**
**D-8000 München 2 (DE)**

(72) Erfinder: **Reinholz, Robby, Dipl.-Ing.**
**Kraepelinweg 17**
**D-1000 Berlin 20 (DE)**

Ein Antrag gemäss Regel 88 EPÜ auf Berichtigung ...... liegt vor. Über diesen Antrag wird im Laufe des Verfahrens vor der Prüfungsabteilung eine Entscheidung getroffen werden (Richtlinien für die Prüfung im EPA, A-V, 2.2).

(54) **Adaptereinrichtung für eine Vorrichtung zum Prüfen von Leiterplatten.**

(57) Bei einer bekannten Adaptereinrichtung ist aus nebeneinander liegenden und im rechten Winkel zur Oberfläche der zu prüfenden Leiterplatte angeordneten Leiterplatten gebildet. An ihrer Eingangsseite weist die bekannte Adaptereinrichtung Kontakte auf, die mittels Leiterbahnen mit Kontaktelementen auf der der Eingangsseite gegenüberliegenden Ausgangsseite verbunden sind.

Die Adaptereinrichtung (30) enthält Adapter-Grundelemente (1) aus paarweise zusammengefügten Leiterplatten (2,3) mit jeweils einer einzigen Reihe von dem Prüfling zugewandten Kontakten (6), die bis zu Kontaktierung (11) von Durchgangslöchern (8) reichen. Unterhalb von jeweils zwei aufeinanderfolgenden Durchgangslöchern (8) ist jeweils ein weiteres Durchgangsloch (14) mit gegeneinander isolierter Kontaktierung (13,15) angeordnet, die über Leiterbahnen mit den Kontaktierungen (11) der einen Durchgangslöcher (8) verbunden sind. Kontaktelemente (19,20) reichen von außen bis zu den Kontaktierungen (13,15).

Die Adaptereinrichtung ist aus den Adapter-Grundelementen entsprechend der Prüfpunkt-Anordnung auf der jeweils zu prüfenden Leiterplatte individuell zusammenstellbar.

FIG 2

## Beschreibung

### Adaptereinrichtung für eine Vorrichtung zum Prüfen von Leiterplatten

Die Erfindung bezieht sich auf eine Adaptereinrichtung für eine Vorrichtung zum Prüfen von Leiterplatten mit einem an einer Auswerteanordnung angeschlossenen elektrischen Kontaktfeld an das über die Adaptereinrichtung die jeweils zu überprüfende Leiterplatte anschließbar ist, wobei die Adaptereinrichtung aus mehreren, nebeneinanderliegenden und im rechten Winkel zur Oberfläche der zu prüfenden Leiterplatte angeordneten Leiterplatten besteht und an ihrer der zu prüfenden Leiterplatte zugewandten Eingangsseite Kontakte aufweist, die mittels Leiterbahnen mit dem Kontaktfeld zugewandten Kontaktelementen auf der der Eingangsseite gegenüberliegenden Ausgangsseite der Adaptereinrichtung verbunden sind.

Bei einer bekannten Adaptereinrichtung dieser Art (EP 0 142 119 B1) sind die die Adaptereinrichtung bildenden Leiterplatten sowohl auf ihrer der zu prüfenden Leiterplatte zugewandten Eingangsseite als auch auf der dieser gegenüberliegenden Ausgangsseite mit Kontaktflächen versehen, die über Leiterbahnen untereinander verbunden sind. Dabei liegen die Kontakte zur zu prüfenden Leiterplatte bildenden Kontaktflächen auf der Eingangsseite der Leiterplatten beispielsweise in einem dem halben normalen Rastermaß entsprechenden Abstand voneinander, während die Kontaktelemente zum elektrischen Kontaktfeld bildenden Kontaktflächen auf der Ausgangsseite der Leiterplatten in einem dem normalen Rastermaß entsprechenden Abstand angeordnet sind. Die Leiterplatten der bekannten Adaptereinrichtung stellen demzufolge Reduzierplatten dar. Durch übereinander Anordnen jeweils zweier Sätze von Leiterplatten in sich kreuzender Lage läßt sich dann eine zu prüfende Leiterplatee mit Prüfpunkten im halben Rastermaß mit dem elektrischen Kontaktfeld im normalen Rastermaß verbinden, so daß auch derartige Leiterplatten mit einer Vorrichtung mit einem Kontaktfeld im normalen Rastermaß prüfbar sind.

Gemäß der Erfindung enthält bei einer Adaptereinrichtung der eingangs angegebenen Art erfindungsgemäß die Adaptereinrichtung Adapter-Grundelementen aus paarweise zusammengefügten Leiterplatten, und jedes Adapter-Grundelement trägt eine einzige Reihe der Kontakte und weist unterhalb jedes Kontaktes ein durchkontaktiertes Durchgangsloch auf, bis zu dessen Kontaktierung die Kontakte jeweils reichen; unterhalb von jeweils zwei aufeinanderfolgenden Durchgangslöchern ist in den Leiterplatten des Adapter-Grundelementes jeweils ein weiteres Durchgangsloch mit gegeneinander isolierter Kontaktierung im Bereich der beiden Leiterplatten angeordnet, und über die Leiterbahnen sind auf den Leiterplatten jeweils die beiden Kontaktierungen eines weiteren Durchgangsloches mit den Kontaktierungen von jeweils zwei aufeinanderfolgenden Durchgangslöchern verbunden, und die Kontaktelemente reichen bis zu den Kontaktierungen der weiteren Durchgangslöcher.

Ein wesentlicher Vorteil der erfindungsgemäßen Adaptereinrichtung besteht darin, daß diese modulartig aus Adapter-Grundelementen aus paarweise zusammengefügten Leiterplatten aufgebaut ist, so daß aus den Adapter-Grundelementen jeweils eine Adaptereinrichtung entsprechend der Prüfpunkt-Anordnung auf der jeweils zu prüfenden Leiterplatte zusammengestellt werden kann. Die Adapter-Grundelemente lassen sich in vorteilhafter Weise aus "Meterware" herstellen, die aus zwei zusammengefügten Leiterplatten mit Durchkontaktierungen im Bereich der einen Durchgangslöcher und weiteren Durchkontaktierungen im Bereich der weiteren Durchgangslöcher unter Zwischenlage einer Isolierschicht besteht. Durch Abtrennen von entsprechend langen Abschnitten aus einem solchen Zwischenprodukt lassen sich dann Adapter-Grundelemente mit entsprechend vielen Kontakten auf der Eingangsseite bzw. Kontaktelementen auf der Ausgangsseite bilden. Die Herstellung der Adapter-Grundelemente und damit der erfindungsgemäßen Adaptereinrichtung ist dadurch erheblich erleichtert.

Dabei ist es möglich, außerhalb des normalen Rastermaßes auf der zu prüfenden Leiterplatte befindliche Prüfpunkte mit dem elektrischen Kontaktfeld im normalen Rastermaß zu verbinden, indem mehrere Adapter-Grundelemente nebeneinander angeordnet werden und die Kontakte auf der Eingangsseite quer zur Längserstreckung der Eingangsseite entsprechend seitlich versetzt angeordnet werden.

Mit besonderem Vorteil läßt sich die erfindungsgemäße Adaptereinrichtung für die Prüfung von Leiterplatten mit Prüfpunkten entsprechend integrierten Bausteinen einsetzen, bei denen gemäß dem Standard SO für SMD-Bauelemente (international genormt nach JEDEC MS - 013 - AD, Ausgabe A, Juni 1985) die Lötpunkte in parallelen Reihen an der Unterseite der Bausteine angeordnet sind; entsprechend liegen dann die Prüfpunkte auf der zu prüfenden Leiterplatte. Zur Prüfung derartiger Leiterplatten werden zwei Adapter-Grundelemente nebeneinander angebracht und die Abstände ihrer Reihen von Kontakten auf der Eingangsseite derart gewählt, daß die Reihen der Kontakte im Abstand der Reihen der Prüfpunkte auf der zu prüfenden Leiterplatte liegen. Das Verschieben der Lage der Kontakte auf der Eingangsseite in Richtung der Durchgangslöcher bzw. parallel dazu ist deshalb möglich, weil die einen Durchgangslöcher über ihre gesamte Länge eine Kontaktierung aufweisen, so daß die von der Eingangsseite her bis zu den einen Durchgangslöchern reichenden Kontakte über die ganze Breite der Eingangsseite eines jeden Adapter-Grundelementes in Kontakt mit der Kontaktierung dieser einen Durchgangslöcher bringbar sind.

Bei der erfindungsgemäßen Adaptereinrichtung können die Kontakte in unterschiedlicher Weise ausgebildet sein. Als vorteilhaft wird es jedoch im Hinblick auf eine verhältnismäßig einfache Fertigung der Adaptereinrichtung angesehen, wenn die Kontakte Kontaktstifte sind, die in von der Eingangsseite des Adapter-Grundelementes her bis zu den Durchgangslöchern eingebrachten Sacklöchern angeordnet sind.

Die Kontaktelemente auf der Ausgangsseite der Adaptereinrichtung bzw. der Adapter-Grundelemente sind in vorteilhafter Weise starre oder federnde Kontaktnadeln, die in von der Ausgangsseite des Adapter-Grundelementes her in jede Leiterplatte bis zu den weiteren Durchgangslöchern eingebrachten Sackbohrungen verlaufen.

Bei der erfindungsgemäßen Adaptereinrichtung liegen die Kontaktelemente im Verlauf der Ausgangsseite der Adaptereinrichtung im normalen Rastermaß nebeneinander und infolge der entsprechend voneinander beabstandeten weiteren Durchgangslöcher in demselben Rastermaß hintereinander auf der Ausgangsseite des Adapter-Grundelementes, so daß dieses unmittelbar zu der Anordnung der Kontaktglieder im elektrischen Kontaktfeld paßt.

Die Kontakte auf der Eingangsseite des Adapter-Grundelementes können im Hinblick auf die Lage der Prüfpunkte der zu prüfenden Leiterplatte unterschiedlich angeordnet sein. Besonders vorteilhaft ist eine Anordnung der Kontakte in einem der Hälfte des normalen Rastermaßes entsprechenden Abstand auf der Eingangsseite des Adapter-Grundelementes, weil sich mit einem derartigen Grundelement Leiterplatten mit Prüfpunkten für die meisten international genormt, integrierten SMD-Bausteine prüfen lassen.

Die Adapter-Grundelemente können zur Bildung der erfindungsgemäßen Adaptereinrichtung in unterschiedlicher Weise zusammengefügt sein. Oben ist bereits darauf hingewiesen worden, daß mit Vorteil ein nebeneinander Anordnen der Adapter-Grundelemente vorgenommen werden kann. Als vorteilhaft wird es auch angesehen, wenn die Adapter-Grundelemente unter Bildung eines Rahmens zusammengefügt sind. Die Bildung eines derartigen Rahmens aus Adapter-Grundelementen ist dann vorteilhaft, wenn die zu prüfende Leiterplatte Prüfpunkte entsprechend integrierten Bausteinen mit Lötanschlußpunkten entsprechend dem Standard PLCC (Internationale Norm JEDEC MO - 047 - AA, Ausgabe A, 1984) oder in einer ähnlichen Anordnung aufweisen. Bei derartigen integrierten Bausteinen sind die Lötanschlüsse in Reihen im Viereck angeordnet.

Nur in seltenen Fällen und gewissermaßen nur zufällig ergibt sich beim Prüfen von Leiterplatten eine Lage der zu prüfenden Leiterplatte zu der Adaptereinrichtung derart, daß die Kontakte der Adaptereinrichtung alle Prüfpunkte auf der zu prüfenden Leiterplatte berühren. Häufig ist vielmehr vor dem Prüfen ein Ausrichten der Adaptereinrichtung in bezug auf die zu prüfende Leiterplatte erforderlich. Um dies zu erleichtern, ist gemäß einer Weiterbildung der Erfindung die Anzahl der Kontakte und der Kontaktelemente des Adapter-Grundelementes gemessen an der Zahl der jeweils reihenweise auf der zu prüfenden Leiterplatte angeordneten Prüfstellen um Eins erhöht. Geht man beispielsweise von dem Fall aus, daß auf der zu prüfenden Leiterplatte die Prüfpunkte in der Reihe einen Abstand von 1/20" aufweisen und auf dem elektrischen Kontaktfeld die Kontaktglieder im 1/10"-Rastermaß angeordnet sind, dann ist eine mögliche Verschiebung der Adaptereinrichtung in bezug auf die zu prüfende Leiterplatte dahingehend beschränkt, daß bei einer Verschiebung von 1/20" die Kontaktelemente auf Zwischenräume im Kontaktfeld geraten. Durch die Verwendung jeweils eines überzähligen Kontaktes sowie Kontaktelementes ist sichergestellt, daß bei einer Verschiebung in der Größenordnung von 1/20" der zusätzliche Kontakt und das zusätzliche Kontaktelement wirksam wird.

Eine andere Möglichkeit der Ausrichtung einer Adaptereinrichtung mit rahmenförmiger Anordnung in bezug auf die zu prüfende Leiterplatte besteht darin, daß die Kontakte gegenüber einer punktsymmetrischen Anordnung bezüglich einer Längsachse durch den Rahmen in wenigstens einer Richtung um 1/4 des normalen Rastermaßes des elektrischen Kontaktfeldes verschoben sind.

Zur Erläuterung der Erfindung ist in

Figur 1 eine perspektivische Darstellung eines Ausführungsbeispiels eines Adapter-Grundelementes der erfindungsgemäßen Adaptereinrichtung, in

Figur 2 ein Ausführungsbeispiel einer Adaptereinrichtung mit zwei nebeneinander angeordneten Adapter-Grundelementen, in

Figur 3 eine Aufsicht auf ein weiteres Ausführungsbeispiel der erfindungsgemäßen Adaptereinrichtung mit zu einem Rahmen angeordneten Adapter-Grundelementen, in

Figur 4 ein Schnitt entlang der Linie IV-IV der Figur 3, in

Figur 5 eine weitere Aufsicht auf ein weiteres Ausführungsbeispiel der erfindungsgemäßen Adaptereinrichtung mit einen Rahmen bildenden Adapter-Grundelementen mit zusätzlichem Kontakt und zusätzlichem Kontaktelement und in

Figur 6 eine Darstellung zur Veranschaulichung der Ausrichtmöglichkeiten einer Adaptereinrichtung gemäß Figur 5 im Hinblick auf eine zu prüfende Leiterplatte gezeigt.

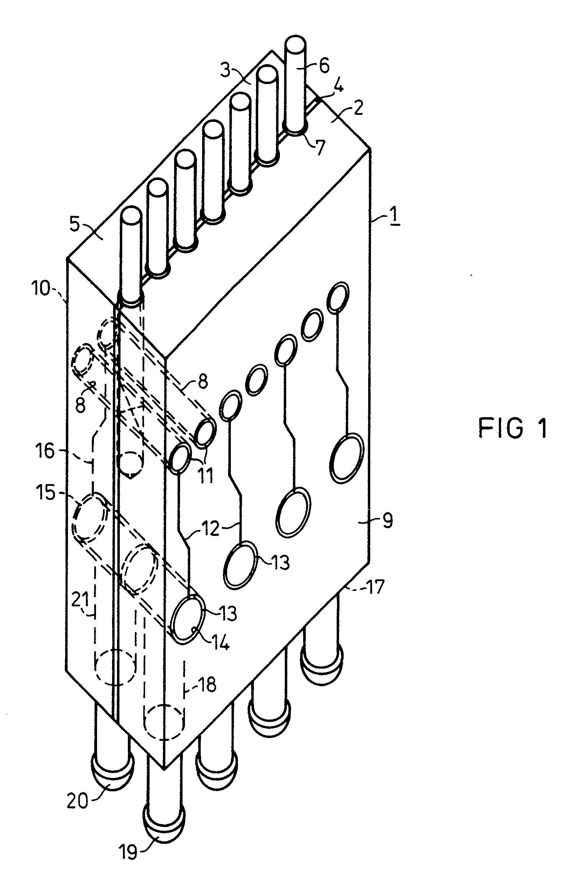

Das in Figur 1 dargestellte Adapter-Grundelement 1 enthält eine Leiterplatte 2 und eine weitere Leiterplatte 3. Die Leiterplatten 2 und 3 sind unter Zwischenlage einer Isolierschicht 4 zusammengefügt. Das so gebildete Adapter-Grundelement 1 ist auf seiner Eingangsseite 5 mit Kontakten 6 versehen, die in Sacklöcher 7 eingebracht sind. Die Kontakte 6 bestehen aus Kontaktstiften. Die sie aufnehmenden Sacklöcher 7 sind bis zu Durchgangslöchern 8 im Adapter-Grundelement 1 geführt. Diese Durchgangslöcher 8 verlaufen quer zur Reihe der Kontakte 6 und sind jeweils so eingebracht, daß sich ein Durchgangsloch 8 unterhalb eines Kontaktes 6 befindet. Alle Durchgangslöcher 8 gangslöcher 8 sind durchkontaktiert, was beispielsweise dadurch bewirkt sein kann, daß von der Vorderseite 9 des Adapter-Grundelementes 1 bis zur Rückseite 10 reichende Metallbuchsen als Kontaktierung 11 in die Durchgangslöcher 8 eingesetzt sind. Die Kontaktierungen 11 der Durchgangslöcher 8 sind dadurch mit den Kontakten 6 galvanisch verbunden, das letztere bis zu den Kontaktierungen 11 hineinreichen. In dem Adapter-Grundelement 1 ist somit unterhalb jeder Kontakt 6 mit der Kontaktierung 11 in einem Durchgangsloch 8 verbunden.

Auf der Vorderseite 9 des Adapter-Grundelementes 1 verlaufen Leiterbahnen 12 von den Kontaktierungen 11 der Durchgangslöcher 8 zu Kontaktierungen 13 von weiteren Durchgangslöchern 14 im Adapter-Grundelement 1. Diese Kontaktierungen 13 sind jeweils im Bereich der Leiterplatte 2 vorgesehen. Im Bereich der Leiterplatte 3 ist eine Kontaktierung 15 im weiteren Durchgangsloch 14 vorhanden. Die Kontaktierungen 13 und 15 sind elektrisch gegeneinander durch die Isolierschicht 4 isoliert.

Die weiteren Durchgangslöcher 14 des Adapter-Grundelementes 1 sind jeweils so angeordnet, daß ein weiteres Durchgangsloch unterhalb von zwei aufeinanderfolgenden Durchgangslöchern 8 liegt. So läßt sich dann die Kontaktierung 11 des in der Figur 1 ganz links liegenden Durchgangsloches 8 über die Leiterbahn 12 mit der Kontaktierung 13 des ganz links liegenden weiteren Durchgangsloches 14 und das in der Figur 1 nächstfolgende Durchgangsloch 8 über eine weitere Leiterbahn 16 auf der Leiterplatte 3 mit der Kontaktierung l5 des weiteren Durchgangsloches 14 verbinden. In entsprechender Weise sind jeweils zwei aufeinanderfolgende weitere Durchgangslöcher 8 mit ihrer Kontaktierung 11 mit Kontaktierungen 13 bzw. 15 in weiteren Durchgangslöchern 14 verbunden.

Im vorliegenden Fall ist angenommen, daß die Kontakte 6 in einem Abstand aufeinanderfolgen, der der Hälfte des normalen Rastermaßes von Prüfpunkten auf einer zu prüfenden Leiterplatte, also 1/20" entspricht. Ferner ist davon ausgegangen, daß mit dem Adapter-Grundelement 1 an seiner Ausgangsseite 17 eine Verbindung zu einem in Figur 1 nicht dargestellten elektrischen Kontaktfeld hergestellt werden soll, dessen Kontakte im normalen Rastermaß von 1/10" voneinander entfernt angeordnet sind. Demzufolge befinden sich bei dem dargestellten Ausführungsbeispiel die weiteren Durchgangslöcher 14 in einem Abstand von 1/10" voneinander entfernt, und es sind in Bohrungen 18, die von der Ausgangsseite 17 her eingebracht sind, Kontaktelemente 19 vorgesehen, die bis zu der Kontaktierung 13 des weiteren Durchgangsloches 14 reichen. Demzufolge liegen die Kontaktelemente 19 auf der Ausgangsseite 17 des Adapter-Grundelementes 1 in einem dem normalen Rastermaß entsprechenden Abstand hintereinander.

Die Anordnung von Kontaktelementen 20 in der Leiterplatte 3 des Adapter-Grundelementes 1 ist entsprechend den Kontaktelementen 19 vorgenommen, indem die Kontaktelemente 20 in bis zu der Kontaktierung 15 reichenden Bohrungen 21 eingesetzt sind. Dabei weisen die Bohrungen 18 und 21 einen Abstand im normalen Rastermaß auf. Dies bedeutet, daß mit dem in Figur 1 dargestellten Adapter-Grundelement 1 Kontakte 6 und damit mit diesen Kontakten in Verbindung gebrachte Prüfpunkte auf einer nicht dargestellten Leiterplatte mit Kontaktgliedern in einem nicht dargestellten, unterhalb des Adapter-Grundelementes vorhandenen elektrischen Kontaktfeld elektrisch verbunden werden können, auf dem die Kontaktglieder im normalen Rastermaß angeordnet sind.

Die Herstellung des in Figur 1 dargestellten Adapter-Grundelementes 1 ist dadurch verhältnismäßig einfach, daß der Block aus den Leiterplatten 2 und 3 mit der Isolierschicht 4 aus einer vorgefertigten größeren Leiterplatteneinheit ausgeschnitten ist, der Block also aus einer angelieferten Meterware herausgetrennt ist.

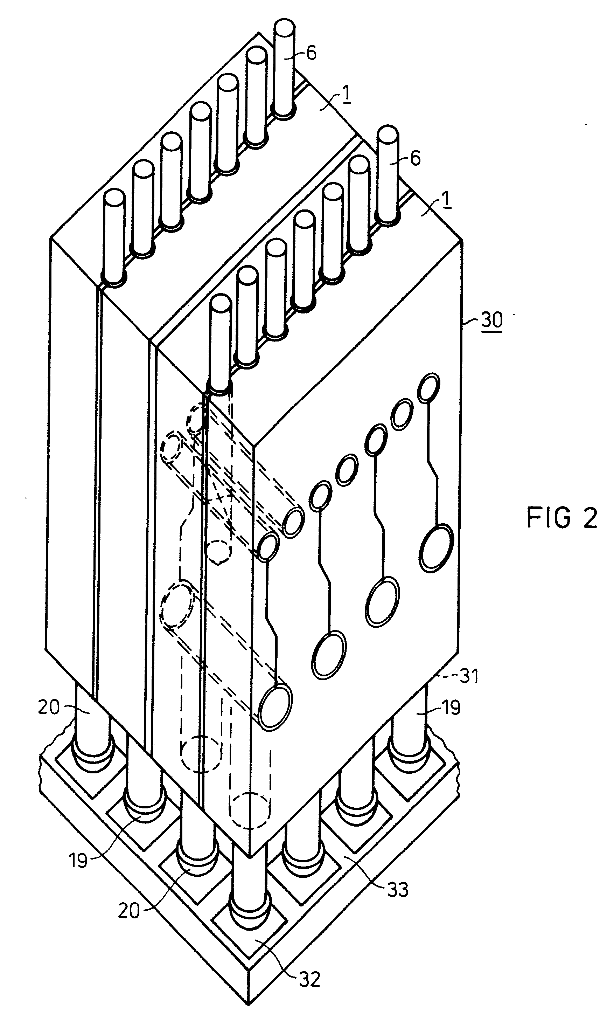

In der Figur 2 ist eine Adaptereinrichtung 30 aus zwei Grundelementen 1 dargestellt wie sie im einzelnen anhand der Figur 1 beschrieben worden sind. Dabei ist die Adaptereinrichtung 30 dadurch gebildet, daß ein Adapter-Grundelement 1 nach Figur 1 mit seiner Rückseite 10 mit der Vorderseite 9 eines weiteren Grundelementes 1 verbunden, beispielsweise verklebt ist. Die Verbindung der beiden Adapter-Grundelemente 1 ist dabei so getroffen, daß auf der Ausgangsseite 31 der Adaptereinrichtung 30 die Kontaktelemente 19 bzw. 20 so angeordnet sind, daß sie im normalen Rastermaß beabstandet sind. In diesem Falle liegen die Kontaktelemente 19 bzw. 20 in die Mitte auf Kontaktgliedern 32 eines elektrischen Kontaktfeldes 33 auf, das in nicht dargestellter Weise mit einer elektrischen Auswerteeinrichtung über Leitungen verbunden ist. Oberhalb der dargestellten Adaptereinrichtung 30 erfolgt die Verbindung ihrer Kontakte 6 mit einer Prüfpunktanordnung im SO-Standard auf einer ebenfalls nicht dargestellten zu prüfenden Leiterplatte.

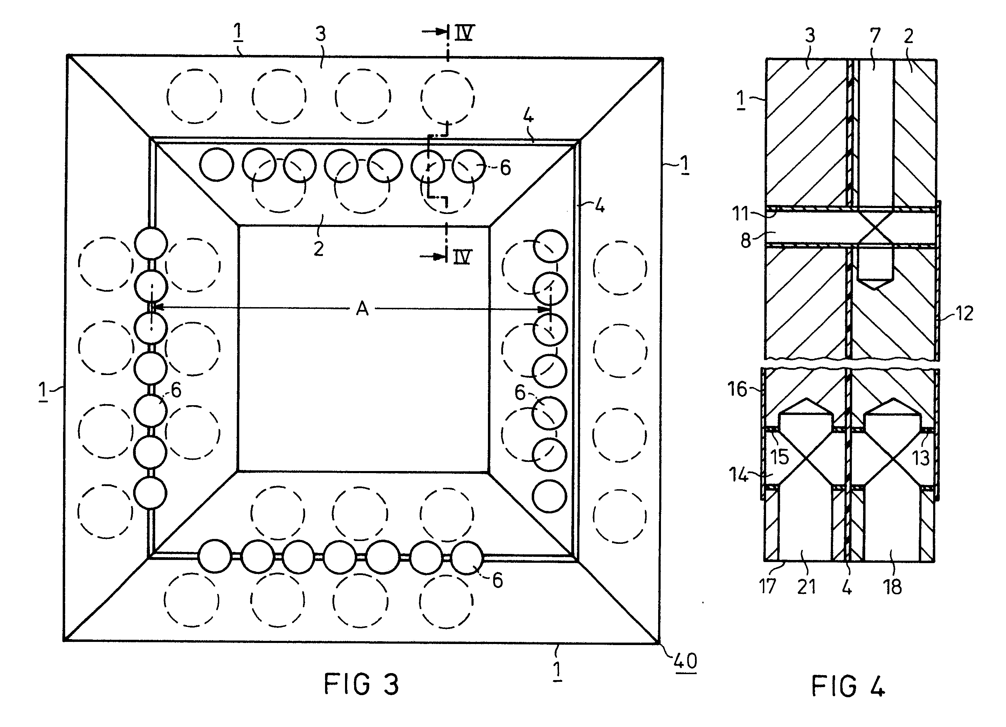

Bei dem Ausführungsbeispiel nach Figur 3 sind vier Adapter-Grundelemente 1 zu einem Rahmen zusammengefügt, in dem sie an ihren Enden jeweils auf Gehrung geschnitten und miteinander verklebt sind. Damit ist dann eine Adaptereinrichtung 40 gewonnen, die zur Prüfung von Leiterplatten mit im Viereck angeordneten Reihen von Prüfpunkten geeignet ist; eine derartige Anordnung von Prüfpunkten ergibt sich dann, wenn auf der zu prüfenden Leiterplatte integrierte Bausteine mit Lötanschlüssen gemäß dem PLCC-Standard aufgebracht werden sollen. Im dargestellten Beispiel ist angenommen, daß jeweils 7 Prüpunkte im Viereck auf der nicht dargestellten, zu prüfenden Leiterplatte vorhanden sind, weshalb die Adaptereinrichtung 40 bezüglich jedes Adapter-Grundelementes 1 mit sieben Kontakten 6 versehen ist. Es ist ferner davon ausgegangen, daß gegenüberliegende Prüfpunkte auf der zu prüfenden Leiterplatte nicht im normalen Rastermaß voneinander entfernt aneinander gegenüberliegen. Um einem dem den Abstand A zwischen jeweils einander gegenüberliegenden Prüfpunkten entsprechenden Abstand zwischen den Reihen von einander gegenüberliegenden Kontakten 6 zu erreichen, sind bei dem in der Figur 3 rechten Adapter-Grundelement 1 die Kontakte 6 aus der Ebene der Zwischenschicht 4 nach links verschoben eingesetzt. Dies läßt sich bei dem Adapter-Grundelement 1 ohne weiteres durchführen, da - wie insbesondere die Figur 1 zeigt - bei einer Verschiebung der Kontakte 6 entlang dem Durchgangsloch 8 eine Kontaktgabe zwischen dem Kontakt 6 und der Durchkontaktierung 11 des Durchgangsloches 8 ermöglicht ist. Die Lage der Kontaktelemente 19 bzw. 20 an der Ausgangsseite der Adaptereinrichtung 40 ist dadurch nicht berührt. Entsprechend sind bei dem Ausführungsbeispiel nach Figur 3 die Kontakte 6 im oberen Adapter-Grundelement 1 aus der Ebene der Zwischenschicht 4 nach unten hin entsprechend verschoben, so daß somit die Reihen der Kontakte 6 im oberen und im unteren Adapter-Grundelement 1 ebenfalls den Abstand A voneinander aufweisen.

Der in Figur 4 dargestellte Schnitt entlang der Linie IV-IV nach Figur 3 zeigt deutlich den Versatz der Sacklöcher 7 in der Leiterplatte 2 des oberen Adapter-Grundelementes 1 nach Figur 3. Ferner ist in Figur 4 deutlich die Kontaktierung 11 im Durchgangsloch 8 des dargestellten Adapter-Grundelementes 1 zu erkennen, die ggf. auch durch eine Metallisierung erreicht sein kann. Der Kontakt 6 ist in Figur 4 nicht dargestellt; er reicht bis in den Bereich der Kontaktierung 11, wodurch eine galvanische Verbindung von Kontakt 6 und Kontaktierung 11 bewirkt ist. Im unteren Teil der Figur 4 ist deutlich zu erkennen, daß die Kontaktierungen 13 und 15 des weiteren Durchgangsloches 14 durch die Isolierzwischenschicht 4 gegeneinander isoliert angeordnet sind. Ferner sind die Sackbohrungen 18 und 21 zu erkennen, die bis über die Kontaktierungen 13 und 15 in die Leiterplatten 2 bzw. 3 hineinreichen, so daß an der Unterseite 17 eingeführte Kontaktelemente in elektrischen Kontakt mit den Kontaktierungen 13 und 15 gelangen. Über die Leiterbahn 12 ist die Kontaktierung 13 mit der Kontaktierung 11 elektrisch verbunden. Die Leiterbahn l6 auf der in Figur 4 linken Seite des Adapter-Grundelementes führt zu der Kontaktierung 11 eines Durchgangsloches 8, das in der Zeichenebene hinter dem dargestellten Durchgangsloch 8 liegt.

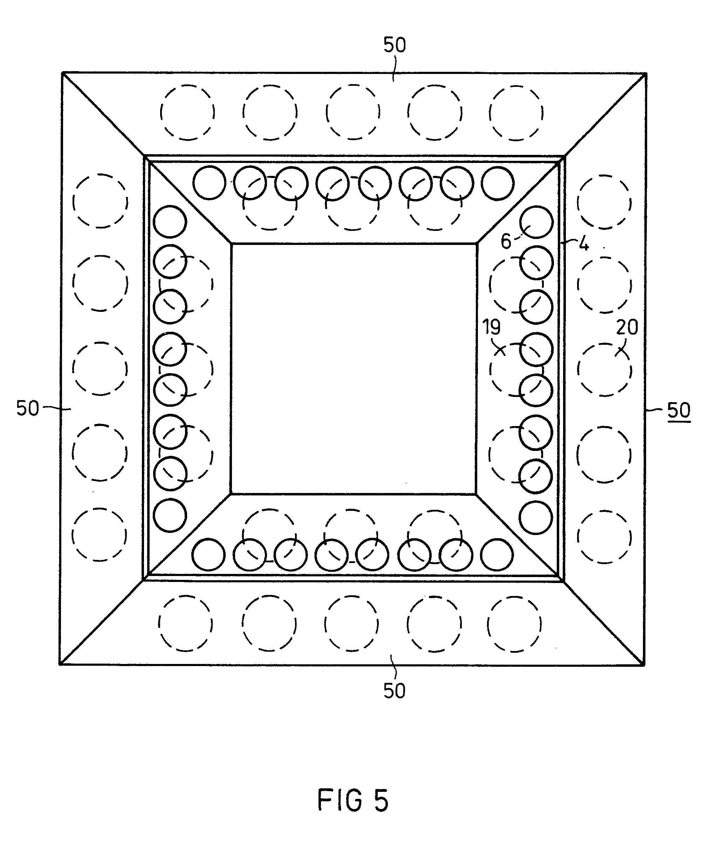

Das Prüfen von Leiterplatten mit Prüfpunkten im halben Rastermaß gelingt mit der erfindungsgemäßen Adaptereinrichtung ohne weiteres, wenn eine Ausrichtung auf die zu prüfende Leiterplatte durch Verschieben der Adaptereinrichtung bis zur Hälfte des Rastermaßes in beiden Richtungen auf dem elektrischen Kontaktfeld erreicht ist. Eine Verschiebung um genau das halbe Rastermaß bringt jedoch Schwierigkeiten, weil in diesem Falle -ausgehend von einer Ausrichtung, bei der die Kontaktelemente genau auf der Mitte der Kontaktglieder des elektrischen Kontaktfeldes aufliegen - die Kontaktelemente auf Isolierzwischenräume des elektrischen Kontaktfeldes treffen. Um in jedem Falle eine Prüfung mit entsprechender Ausrichtung der Adaptereinrichtung zur zu prüfenden Leiterplatte zu ermöglichen, ist gemäß dem Ausführungsbeispiel nach Figur 5 jedes Adapter-Grundelement 50 mit einem zusätzlichen Kontakt in der Reihe der Kontakte 6 auf der Eingangsseite und einem zusätzlichen Kontaktelement auf der Ausgangsseite versehen. Jedes Adapter-Grundelement 50 weist deshalb zusätzlich zu den im dargestellten Fall für sieben Lötanschlußpunkte auf der zu prüfenden Leiterplatte vorgesehenen sieben Kontakte 6 einen zusätzlichen achten Kontakt auf und auch acht Kontaktelemente 19 und 20. Wie Figur 5 ferner zeigt, sind die Kontakte 6 sämtlich aus dem Bereich der Isolierzwischenschicht 4 nach innen um eine Strecke verschoben, die zur Anpassung an den Abstand gegenüberliegender Reihen von Prüfpunkten auf der zu prüfenden Leiterplatte erforderlich ist.

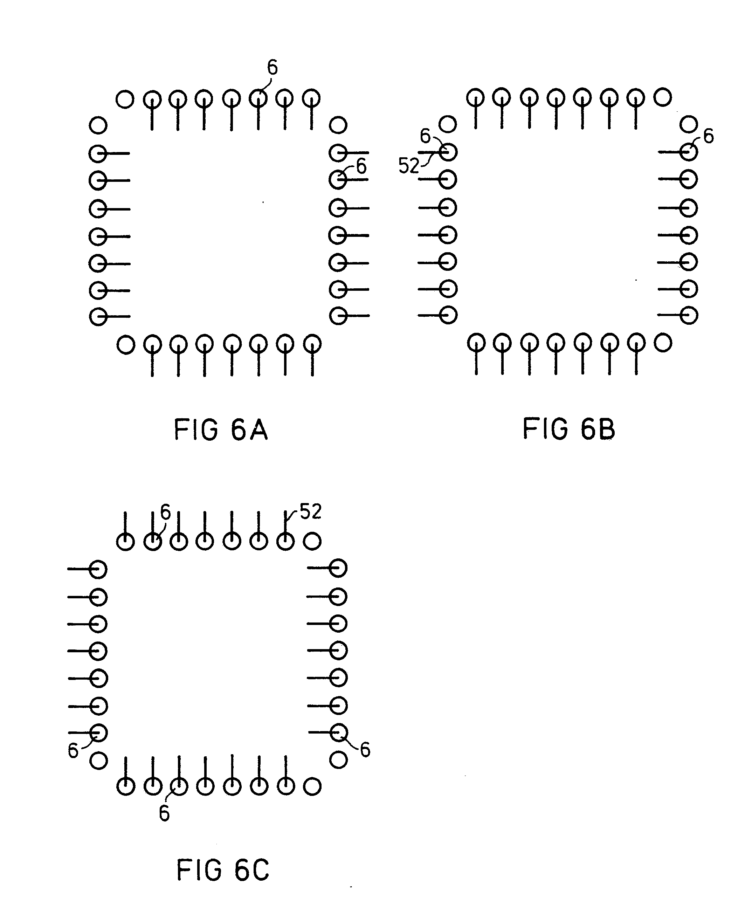

Die in Figur 5 gezeigte Anordnung der Kontakte 6 bzw. der Kontaktelemente 19 und 20 ermöglicht eine Ausrichtung der Adaptereinrichtung in bezug auf die zu prüfende Leiterplatte in einem Umfange, wie es anhand der Figur 6 veranschaulicht ist. Dabei zeigt die Darstellung A der Figur 6 die Kontakte 6 einer im übrigen nicht weiter dargestellten Adaptereinrichtung gemäß Figur 5 in einer ausgerichteten Lage zu den Lötanschlüssen 52 einer ebenfalls nicht dargestellten, zu prüfenden Leiterplatte, wobei die Lötanschlüsse gemäß dem PLCC-Standard angeordnet sind. Es ist hierbei der jeweils links liegende Kontakt 6 der waagerecht dargestellten Kontaktreihen und jeweils der oberste Kontakt 6 der vertikal dargestellten Kontaktreihen unbenutzt. Bei der Darstellung 8 der Figur 6 ist davon ausgegangen, daß die Lage der zu prüfenden Lötanschlüssen auf der zu prüfenden Leiterplatte gegenüber dem elektrischen Kontaktfeld um 1/20″ nach links verschoben ist. In diesem Falle wird der in Darstellung A linke Kontakt der oberen Reihe und der unteren Reihe von Kontakten 6 der Adaptereinrichtung zur Kontaktgabe mit den Lötanschlüssen benutzt, und der rechte Kontakt der oberen und unteren Reihe von Kontakten bleibt frei. Die in Darstellung B linke Reihe der Kontakte 6 der Adaptereinrichtung befindet sich nach wie vor im Kontakt mit den Lötanschlüssen 52 auf der zu prüfenden Leiterplatte, weil diese Anschlüsse eine verhältnismäßig große Länge aufweisen. Entsprechendes gilt für die Kontakte 6 der rechten Kontaktreihe in Darstellung B. Damit ist gezeigt, daß auch für den Fall, daß die Prüfpunktanordnung auf einer zu prüfenden Leiterplatte um 1/20″ bezüglich des elektrischen Kontaktfeldes mit dem normalen Rastermaß von 1/10″ nach links verschoben ist, noch eine Verbindung der Lötanschlüsse 52 der zu prüfenden Leiterplatte über die erfindungsgemäße Adaptereinrichtung mit dem elektrischen Kontaktfeld möglich ist.

Gemäß Darstellung C der Figur 6 ist angenommen, daß die zu prüfende Leiterplatte mit ihren Lötanschlüssen 52 in der anderen Richtung in bezug auf das elektrische Kontaktfeld um die Hälfte (1/20″) des normalen Rastermaßes verschoben ist. Dann ändert sich bezüglich der oberen und unteren Reihe der Kontakte 6 in bezug auf die Kontaktgabe mit den Lötanschlüssen der zu prüfenden Leiterplatte nichts; anders verhält es sich jedoch mit der in der Figur linken bzw. rechten Reihe von Kontakten 6, weil diese ihre Lage zu den Lötanschlüssen 52 auf der zu prüfenden Leiterplatte verändern, indem nunmehr der in der Darstellung C jeweils untere Kontakt 6 frei wird und der jeweils obere Kontakt in Kontakt mit dem Lötanschluß 52 der zu prüfenden Leiterplatte gelangt.

Es ist somit eine einfache Möglichkeit geschaffen, die Adaptereinrichtung gemäß der Erfindung zu der zu prüfenden Leiterplatte auszurichten.

**Patentansprüche**

1. Adaptereinrichtung für eine Vorrichtung zum Prüfen von Leiterplatten mit einem an eine Auswerteanordnung angeschlossenen elektrischen Kontaktfeld, an das über die Adaptereinrichtung die jeweils zu prüfende Leiterplatte anschließbar ist, wobei die Adaptereinrichtung aus mehreren nebeneinanderliegenden und im rechten Winkel zur Oberfläche der zu prüfenden Leiterplatte angeordneten Leiterplatten besteht und an ihrer der zu prüfenden Leiterplatte zugewandten Eingangsseite reihenweise angeordnete Kontakte aufweist, die mittels Leiterbahnen mit dem Kontaktfeld zugewandten Kontaktelementen auf der der Eingangsseite gegenüberliegenden Ausgangsseite der Adaptereinrichtung verbunden sind, **dadurch gekennzeichnet,** daß die Adaptereinrichtung (30) Adapter-Grundelemente (1) aus paarweise zusammengefügten Leiterplatten (2,3) enthält, daß jedes Adapter-Grundelement (1) eine einzige Reihe der Kontakte (6) trägt und unterhalb jedes Kontaktes (6) ein durchkontaktiertes Durchgangsloch (8) aufweist, bis zu dessen Kontaktierung (11) die Kontakte (6) jeweils reichen, daß unterhalb von jeweils zwei aufeinanderfolgenden Durchgangslöchern (6) in den Leiterplatten (2,3) des Adapter-Grundelementes (1) jeweils ein weiteres Durchgangsloch (14) mit gegeneinander isolierter Kontaktierung (13, 15) im Bereich der beiden Leiterplatten (2,3) angeordnet ist, daß über Leiterbahnen (12, 16) auf den Leiterplatten (2,3) die beiden Kontaktierungen (13, 15) eines weiteren Durchgangsloches (14) mit den Kontaktierungen (11) von jeweils zwei aufeinanderfolgenden Durchgangslöchern (8) verbunden sind und daß die Kontaktelemente (19, 20) bis zu den Kontaktierungen (I3, 15) der weiteren Durchgangslöcher (14) reichen.

2. Adaptereinrichtung nach Anspruch 1, **dadurch gekennzeichnet,** daß die Kontakte (6> Kontaktstifte sind, die in von der Eingangsseite (5) des Adapter-Grundelementes (1) her bis zu den Durchgangslöchern (8) eingebrachten Sacklöchern (7) angeordnet sind.

3. Adaptereinrichtung nach Anspruch 1 oder 2, **dadurch gekennzeichnet,** daß die Kontaktelemente (19, 20) Kontaktnadeln sind, die in von der Ausgangsseite (17) des Adapter-Grundelementes (1) her in jede Leiterplatte (2, 3) bis zu den weiteren Durchgangslöchern (14) eingebrachten Sackbohrungen (18) verlaufen.

4. Adaptereinrichtung nach einem der vorangehenden Ansprüche, **dadurch gekennzeichnet,** daß die Kontaktelemente (19,20) im Verlauf der Ausgangsseite (I7) der Adaptereinrichtung im normalen Rastermaß nebeneinander und infolge der entsprechend voneinander beabstandeten weiteren Durchgangslöcher (14) in demselben Rastermaß hintereinander auf der Ausgangsseite (17) des Adapter-Grundelementes (1) liegen.

5. Adaptereinrichtung nach einem der vorangehenden Ansprüche, **dadurch gekennzeichnet,** daß die Kontakte (6) in einem der Hälfte des normalen Rastermaßes entsprechenden Abstand auf der Eingangsseite (5) des Adapter-Grundelementes (1) liegen.

6. Adaptereinrichtung nach Anspruch 5, **dadurch gekennzeichnet,** daß die Adapter-Grundelemente (1) unter Bildung eines Rahmens zusammengefügt sind.

7. Adaptereinrichtung nach einem der vorangehenden Ansprüche, **dadurch gekennzeichnet,** daß die Anzahl der Kontakte (6) und der Kontaktelemente (19, 20) des Adapter-Grundelementes (1) gemessen an der Anzahl der jeweils reihenweise auf der zu prüfenden Leiterplatte angeordneten Prüfstellen um eins erhöht ist.

8. Adaptereinrichtung nach Anspruch 6, **dadurch gekennzeichnet,** daß die Kontakte gegenüber einer punktsymmetrischen Anordnung bezüglich einer Längsachse durch den Rahmen in wenigstens einer Richtung um ein Viertel des normalen Rastermaßes verschoben sind.

FIG 1

FIG 2

FIG 4

FIG 3

FIG 5

FIG 6A

FIG 6B

FIG 6C

Europäisches Patentamt

**EUROPÄISCHER RECHERCHENBERICHT**

Nummer der Anmeldung

EP 89 73 0036

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | EP-A-0 142 119 (MANIA) <br> * Zusammenfassung; Figuren 1,2 * <br> --- | 1-5 | G 01 R 1/073 <br> G 01 R 31/28 <br> H 01 R 31/06 |
| A | FR-A- 530 039 (GRANET) <br> * Seite 1, Zeilen 30-51; Figuren * <br> --- | 1-3 | |
| A | WO-A-8 505 229 (BONHOMME) <br> * Seite 14, Zeilen 25-28; Figuren 2,4 * <br> ----- | 1 | |

**RECHERCHIERTE SACHGEBIETE (Int. Cl.4)**

G 01 R
H 01 R

Der vorliegende Recherchenbericht wurde für alle Patentansprüche erstellt

| Recherchenort | Abschlußdatum der Recherche | Prüfer |
|---|---|---|
| DEN HAAG | 30-05-1989 | HARRISON R.J. |